(19) Europäisches Patentamt / European Patent Office / Office européen des brevets

(11) **EP 2 840 387 A1**

(12) **EUROPEAN PATENT APPLICATION**

(43) Date of publication:
**25.02.2015 Bulletin 2015/09**

(51) Int Cl.:
***G01N 25/72*** (2006.01)   ***G01R 31/309*** (2006.01)

(21) Application number: **13181506.0**

(22) Date of filing: **23.08.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
- **DCG Systems, Inc.**
  **Fremont, CA 94538 (US)**
- **Fraunhofer-Gesellschaft zur Förderung der angewandten Forschung e.V.**
  **80686 München (DE)**

(72) Inventors:
- **Schmidt, Christian**
  **91058 Erlangen (DE)**

- **Meinhardt-Wildegger, Raiko**
  **91058 Erlangen (DE)**
- **Altmann, Frank**
  **06118 Halle (DE)**
- **Naumann, Falk**
  **06160 Halle (DE)**

(74) Representative: **Puschmann Borchert Bardehle Patentanwälte Partnerschaft mbB**
  **Postfach 10 12 31**
  **80086 München (DE)**

Remarks:
Amended claims in accordance with Rule 137(2) EPC.

(54) **Lock-in thermography method and system for hot spot localization**

(57)   A method and a system for localizing hot spots in a sample by using lock-in thermography (LIT) where at least one heat source of an electrical circuit is buried within the sample, comprising:

applying a non-harmonic test signal to the electrical circuit of the sample to activate the heat source for generating the hot spot; imaging the sample using an infrared sensor to obtain IR images of the sample while the non-harmonic test signal is applied to the electrical circuit; detecting a thermal response signal obtained from the images being in correlation to thermal heat propagation within the sample; subjecting the response signal to a fast Fourier transformation (FFT) to break down the response signal into a frequency spectrum containing harmonics signals of a base harmonic sine or cosine signal as frequency specific response signals at multiple specific frequencies; determining the phase shifts of the frequency specific response signals at the multiple specific frequencies at specific positions on an image of a surface of the sample, and obtaining a frequency vs. phase shift curve from the determined phase shifts of the frequency specific response signals or a frequency specific image, respectively, related to the depth location of the hot spot in the sample.

Fig. 9

EP 2 840 387 A1

**Description**

The invention is in the field of localizing anomalies using lock-in thermography (LIT) and, more specifically for detecting spatial and depth location of various detected anomalies. Specific examples relate to methods and systems for localizing anomalies in semiconductor integrated circuits, referred to in the art as device under test (DUT), by detecting hot spots caused by anomalies in an electrical circuit buried within the DUT.

In the paper of CHRISTIAN SCHMIDT et al: "Non-destructive defect depth determination at fully packaged and stacked die devices using Lock-in Thermography", PHYSICAL AND FAILURE ANALYSIS OF INTEGRATED CIRCUITS (IPFA, 2010), proceedings 17th IEEE International Symposium on the IEEE, NJ, USA, July 5, 2010 (2010-07-05), pages 1 to 5, XP 031720074, ISBN 978-1-4244-5596-6, a non-destructive approach for the 3D localization of thermally active buried defects in single chip and stacked die architectures by use of lock-in thermography (LIT) is presented. The paper also describes the use of phase shift to deduce the depth of the thermally active buried defect. The basic principal concerns the thermal wave propagation through different material layers and the resulting phase shift. Based on that, the LIT application for 3D defect localization is explained and both fully packaged single chip and stacked die devices are considered while comparing the theoretical and experimental data (results).

WO 2011/156527 A1 refers to three dimensional hot spot localization by use of the lock-in thermography which can detect very small temperature variations across a sample by direct thermal imaging, using an IR sensitive camera combined with pixel-wise two channel lock-in correlation. For quantitative LIT analysis and three-dimensional location of buried heat sources, the basic principles of heat wave propagation and the dependence of the thermal and geometrical properties of the material layer(s) above the hot spot area have to be understood. In the system and the method of WO 2011/156527 A1 test signals are applied to the sample at multiple different lock-in frequencies in order to determine the phase shift values at the various lock-in frequencies. The phase shift is the result of the thermal propagation in the material, thus is indicating of the depth in which the hot spot originated. Also, a frequency vs. phase curve is obtained, from which the depth of a defect in the sample maybe determined. Such frequency vs. phase curve serves to calculate, using a mathematical model of the structure of the DUT, the exact three-dimensional location of the defect causing the hot spot. This exact localization of the defect can also serve for identifying the circuit element which caused the defect.

When testing and examining DUTs, it may be sufficient to determine the general depth location of a defect causing a hot spot, and this information can be used to design further tests and analysis of the DUT. For example, sometimes ion milling or other methods may be used to remove portions of the layered structure of the DUT to expose the defect for further imaging and/or edits. The appropriate location and depth of the milling can be determined using the hot spot localization. Furthermore, from knowing the approximate depth location of a defect, one can also postulate about the characteristics and/or cause of the defect and the general portion of the circuitry where it has occurred.

In view the state of the art as discussed above, there is a definite need for a method and a system for localizing hot spots in a sample by using lock-in thermography (LIT) in a shorter period of time where the sample is, for example, a device under test (DUT).

The following summary of the disclosure is included in order to provide a basic understanding of some aspects and features of the invention. This summary is not an extensive overview of the invention and as such it is not intended to particularly identify key or critical elements of the invention or to delineate the scope of the invention. Its sole purpose is to present some concepts of the invention in a simplified form as a prelude to the more detailed description that is presented below.

According to embodiments of the invention, a method is provided for localizing hot spots in a sample by using lock-in thermography (LIT) where at least one heat source of an electrical circuit is buried within the sample, comprising: applying a non-harmonic test signal to the electrical circuit of the sample to activate the heat source for generating the hot spot; imaging the sample using an infrared sensor to obtain IR images of the sample while the non-harmonic test signal is applied to the electrical circuit; detecting a thermal response signal obtained from the imaging being in correlation to thermal heat propagation within the sample; subjecting the response signal to a Fourier transformation (FT) to break down the response signal into a frequency spectrum containing harmonics signals of a basic harmonic sine or cosine signal as frequency specific response signals at multiple specific frequencies; determining the phase shifts of the frequency specific response signals at the multiple specific frequencies at specific positions on an image of a surface of the sample, and obtaining a frequency vs. phase shift curve from the determined phase shifts of the frequency specific response signals or a frequency specific image, respectively, related to the depth location of the sample.

In embodiments of the invention the non-harmonic test signal is a square pulse test signal which best represents switching on and off of the energy supply to the sample. The non-harmonic test signal is provided at a single selected frequency, which may be the lowest frequency which is expected to generate a response from the DUT. The lowest selected frequency may be set to, e.g., 0.5Hz or 1.0 Hz.

In embodiments of the invention the Fourier transformation is a fast Fourier transformation (FFT) whereby the measurement process per sample is further shortened because the output of the FFT are already individual frequency specific response signals at pre-selectable frequencies.

The method may comprise smoothing the slope of the frequency vs. phase shift curve by square root function to improve the determination of the depth location by evaluating the deviation of the individual measured frequency vs. phase shift point from the smoothed frequency vs. phase shift curve.

In embodiments of the invention the method may further comprise calculating a theoretical sample specific frequency vs. phase shift curve by analytical solution of the thermal wave propagation; and correlating the calculated sample specific frequency vs. phase shift curve to the detected frequency vs. phase shift curve to identify the depth location of the heat source in the sample. As an alternative, embodiments of the invention may comprise calculating a theoretical sample specific frequency vs. phase shift curve by finite element modeling of thermal wave propagation; and correlating the calculated material specific parameter related frequency vs. phase shift behavior to the detected material specific parameter phase shift to identify the depth location of the heat source in the sample. it is considered that the closer the theoretical sample specific frequency vs. phase shift curve is to the measured sample specific frequency vs. phase shift curve the better is the accuracy of the measurements.

In various embodiments of the invention the method may further comprise applying test signal by obtaining the test signal from an external source, such as a conventional Automated Testing Equipment (ATE), and synchronizing an IR camera as the infrared sensor to the signal from the external source. The IR camera may have a two-dimensional IR sensor, and the FFT may be individually applied to an output signal from each pixel of the two-dimensional IR sensor. Following the application of FFT to each signal of the pixels of the IR sensor, a plurality of images may be generated from the resulting signals, wherein each image corresponds to a response of one selected frequency.

Embodiments of the invention may comprise a system for localizing hot spots in a sample by using lock-in thermography (LIT) wherein at least one heat source of an electrical circuit is buried within the sample, comprising: a bench for mounting the sample; an excitation source to apply a non-harmonic test signal to the electrical circuit of the sample to activate the heat source for generating the hot spot; an infrared sensor for imaging the sample to obtain IR images of the sample while the non-harmonic test signal is applied to the electrical circuit; and a processor configured: to read data from the infrared sensor and to use thermal imaging of the infrared sensor to detect a thermal response signal obtained from the imaging being in correlation to thermal heat propagation within the sample; to subject the response signal to a Fourier transformation (FT) to break down the response signal into a frequency spectrum containing harmonics signals of a basic harmonic sine or cosine signal as frequency specific response signals at multiple specific frequencies; and to determine the phase shifts of the frequency specific response signals at the multiple specific frequencies at specific positions on an image of a surface of the sample, and to obtain a frequency vs. phase shift curve from the determined phase shifts of the frequency specific response signals or a frequency specific image, respectively, related to the depth location of the sample.

Embodiments of the invention may comprise a system for localizing a defect within a sample, comprising: a bench for mounting the sample; an excitation source to apply a non-harmonic wave excitation signal to the sample; an infrared sensor for imaging the sample to obtain IR images of the sample; wherein the processor is configured: to read data from the infrared sensor and use thermal imaging of the infrared sensor to generate thermal waveforms by: subjecting the response signal to a Fourier transformation (FT) to break down the response signal into frequency specific response signals at multiple frequencies; and analyzing the phase shifts at the multiple specific frequencies to thereby obtain a frequency vs. phase curve related to the depth of the hot spot in the sample. The above systems may be configured to implement the methods of the invention mentioned above.

An advantage of the system and the method according to the invention is the fact that the phase shift measurement points of a particular frequency vs. phase shift curve can be obtained for a number of lock-in frequencies during one single measurement run using one non-harmonic test signal at one frequency as excitation energy for causing the sample to react in reply to the non-harmonic test signal, where the respective one single response signal is further processed to obtain the phase shift measurement points on the frequency vs. phase shift curve. In other words, there is only one measurement at one frequency necessary for each type of the sample, and the resulting data corresponds to multiple frequencies.

While embodiments of the invention are described herein with respect to encapsulated integrated circuits, the invention can also be implemented for testing other devices that generate hot spots by electrical stimulation, such as batteries, solar cells, power devices, LED's, etc. Therefore, the discussion provided herein with respect to a DUT may be applicable to these devices as well.

Further advantages, features and potential applications of the present invention may be gathered from the description which follows, in conjunction with the embodiments illustrated in the drawings. Throughout the description, the claims and the drawings, those terms and associated reference signs will be used as are notable from the enclosed list of reference signs. The accompanying drawings, which are incorporated in and constitute a part of this specification, exemplify the embodiments of the present invention and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements, and are not drawn to scale. In the drawings is shown

Fig. 1    a cross-section sketch of the experimental setup as shown in WO 2011/156527 Al, where the sample has a buried defect;

Fig. 2    a plot of the resulting phase shift as a function of the applied lock-in frequency resulting from an assumed defect under a one millimeter material layer of silicon and mold compound as shown in WO 2011/156527 Al;

Fig. 3    a general outline of the system for carrying out the method of the invention;

Fig. 4    a plot showing the input square wave test signal and the time resolved response signal diagram showing the delay of the response signal indicative of the depth of the anomaly;

Fig. 5    the use of an FFT for translating a square-wave signal into a plurality of sine signals and converting the plot in the time domain to a plot in the frequency domain, wherein the amplitude in the frequency domain is standardized to 1;

Fig. 6    a schematic view showing the result of the break-down of the captured signal by fast Fourier transformation (FFT);

Fig. 7    a plot in the frequency domain of the captured response signal after the application of the FFT for a sample excited with a square wave signal of frequency 05.Hz;

Fig. 8    the frequency vs. phase shift curve resulting from the phase analysis of the results shown in Fig. 7, and

Fig. 9    the application of FFT to each pixel of a response image captured using a stimulation signal of a single frequency, to construct multiple response images, each corresponding to one selected stimulation frequency.

In the following specification, the invention is explained with reference to a DUT, which is a specific example for the samples to which the present invention may be applied.

Three dimensional architectures of electronic devices e.g. system in packages (SiP) are composed of several integrated circuit dies, die attachment layers, interconnect redistribution layers, etc., all stacked vertically and encapsulated together. Such encapsulated electronic devices are heterogenous material stacks containing silicon, polymer and Si-oxide isolators, metal lines and wires, glue and/or adhesives, encapsulation mold, etc. Therefore, the internal heat propagation starting from the hot spot position can be very complex. Consequently, determining the location of a hot spot defect in the z direction, i.e., its depth within the sample is rather difficult. Furthermore, complex defects or sample types may result in non-ideal hot spot activation in terms of power conversion at the hot spot location. Various embodiments disclosed herein enable accurate localization of heat sources (e.g. thermally active structures or defects) in such devices.

Embodiments of the invention use quantitative measures of the phase shift/time delay between electrical stimulation and thermal response and the shape of the measured waveform for automated and semi-automated data analysis. The waveform shape analysis can be based on cross-correlation between the measured results and pre-defined functions, delivering a correlation matrix rather than just single phase values per applied lock-in frequency.

In general, the DUT is encapsulated in material that is not transparent for optical examination. However, IR wavelength (typically 3-5$\mu$m) thermal waves can propagate through this material, resulting in an increased temperature at the device's surface above the embedded hot spot. This increase in temperature can be imaged by IR camera and measured by LIT. The time constant of the underlying thermal diffusion process determines the phase shift between excitation signal and the thermal response. The main contributors to the thermal delay are the material layers with less heat conductivity, like mold compound, die attach glues, polymer and Si oxide isolators, but not the Si dies or metal layers which have a much higher heat conductivity. In simple terms, the longer the distance between hot spot and device's surface, the higher the resulting phase shift. Thus, knowing the thermal properties of the material above the hot spot allows the determination of an unknown depth of hot spots by measuring the phase shift.

The parameter which describes the influence of the thermal properties of a material layer is herein called thermal diffusion length ($\mu$) which describes the damping of the thermal wave inside the bulk material. The thermal diffusion length $\mu$ (in mm) is characteristic for each material propagated by the thermal wave. It is defined as the characteristic length where the amplitude of the thermal wave is dropped down to $e^{-1}$. It can be calculated, as shown in the equation below, by the thermal parameters: heat conductivity ($\lambda$ in W/m*K), specific heat capacity ($c_p$ in J/g*K), density (p in g/cm$^3$) and the applied lock-in frequency ($f_{lock-in}$ in Hz). The thermal parameters can be summarized as the thermal diffusivity ($a = \lambda/C_p\rho$ in mm$^2$/s).

$$\mu = \sqrt{\frac{2\lambda}{C_p \rho 2\pi f_{lock-in}}} = \sqrt{\frac{2a}{2\pi f_{lock-in}}}$$

Since the thermal diffusion length $\mu$ is characteristic for each material propagated by the thermal wave, the deeper the anomaly is within the DUT, the longer time it takes for the thermal wave to propagate to the surface. Consequently, reducing the frequency of the excitation signal allows sufficient time for the thermal wave to propagate to the surface and be captured by the IR camera, thereby localizing the heat sources even through hundreds of microns of IR-opaque material layers. Due to the fact that the thermal diffusion length can be seen as the damping factor to the thermal wave, it affects not only the amplitude but also the resulting phase. A higher lock-in frequency results in a higher time delay between excitation signal at the hot spot position and the thermal response at the device surface. Therefore, an increase of the phase shift as a function of the increased lock-in frequency has to be expected.

The relationship between phase shift of the phase $\phi$ and hot spot depth z is described as:

$$\Phi = \frac{z}{\mu} * 180/\pi$$

wherein $\mu$ represents the thermal diffusion length.

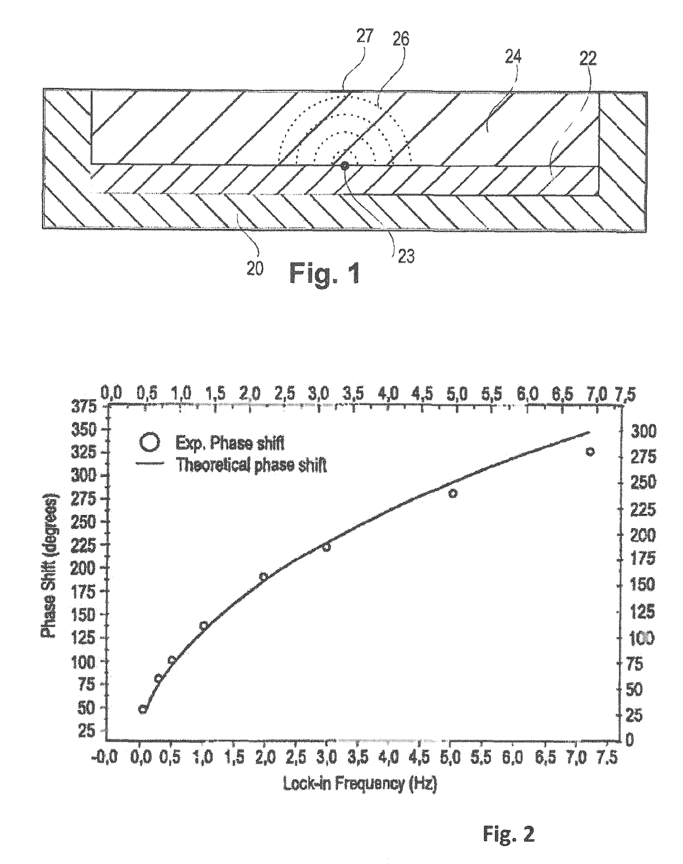

The method of LIT can be used to non-destructively determine the hot spot position inside of a fully packaged single chip device, shown in Fig. 1, providing a better alignment for the following physical failure analysis steps. Fig. 1, illustrates an IC chip 22 inside encapsulation 20 and covered with insulator 24. When current flows through the chip 22, an anomaly 23, e.g., a defect, causes heat waves 26, which propagate to the surface of the insulator 24 and show up as a hot spot 27. The hot spot can be imaged by an IR camera to provide spatial localization of the anomaly. The time delay between the current flow and the appearance of the hot spot on the surface, i.e., the phase shift, can be used to determine the depth of the anomaly.

The relationship between hot spot depth, applied lock-in frequency and resulting phase shift was investigated using test structures with defined point heat sources. The test structures were made using single chip device containing a meander of copper lines. The meander was locally modified by Focused Ion Beam technique (FIB) to generate well-defined local heat source 23. After the creation of the local high resistance area the single chip device was measured by LIT with a supply voltage of 1.2 V and a lock-in frequency of 5Hz, creating a local heat source with a dissipation power of 14 mW. As a next step, the device was encapsulated with mold compound 24 in order to create a material layer between the hot spots and the device surface. In this case the depth of the hot spots was known by the dimension of the device and the single chip and was determined at 950 $\mu$m. As shown in Fig. 1, a dual ceramic in-line package (DCIP) 20 houses the single chip 22 with the created defect 23. A mold compound 24 was filled over the chip 22 to thickness of 950$\mu$m over the top surface of the chip 22.

Based on the theory explained above, the DUT was investigated over a frequency range from 0.1 to 7 Hz and the resulting phase shift was measured. Fig. 2 shows the investigated relationship between applied lock-in frequency and resulting phase shift. The measured data points are plotted over the theoretical curve. It can be seen clearly that the curves match the theoretical data for a lock-in frequency range of 0.1 to 3 Hz, In case of 5 and 7 Hz, a slight mismatch was obtained which can be explained by the low signal to noise ratio (S/N) due to the higher damping of the thermal wave. This influence can be removed by a longer measuring time, due to the fact that the stochastic noise of the detector is reduced by the square root of the measurement time.

The relationship between phase shift and lock-in frequency was determined experimentally for mold compound material with a good correlation to theoretical data as can be seen in Fig. 2. The obtained results are proving the potential of lock-in thermography investigations for 3D localization of thermal active structures or defects within fully package devices.

For 3D hot spot localization inside of stacked die integrated devices, e.g., a system-in-package, a second factor of influence has to be regarded. Thermal waves generated at the hot spot position have to propagate through different material layers, e.g., silicon, mold compound, die attach tape, etc., each having different thicknesses and material properties. As a consequence, depending on the axial hot spot position at different dies of the defective device, not only the distance to the device surface but also the thermal diffusion length is changing. Therefore, thermal waves generated at hot spots at lower dies inside of the stack have to pass additional material layers compared to thermal waves generated at hot spots which are close to the device surface. Like in the previous section regarding single chip devices, this behavior can be used for the determination of the hot spot depth by calculating the theoretical phase shift over a certain frequency range for different hot spot positions. Unlike the investigations of single chip devices, it is assumed that the hot spot is related to a specific die, which leads to the circumstance that a discrete model of the material system can be used. Therefore, at least to a first order, the total thermal diffusion length is the summation of the single thermal diffusion length of each material layer. Also, the total depth of the hot spot is the summation of the thicknesses of the single material layers.

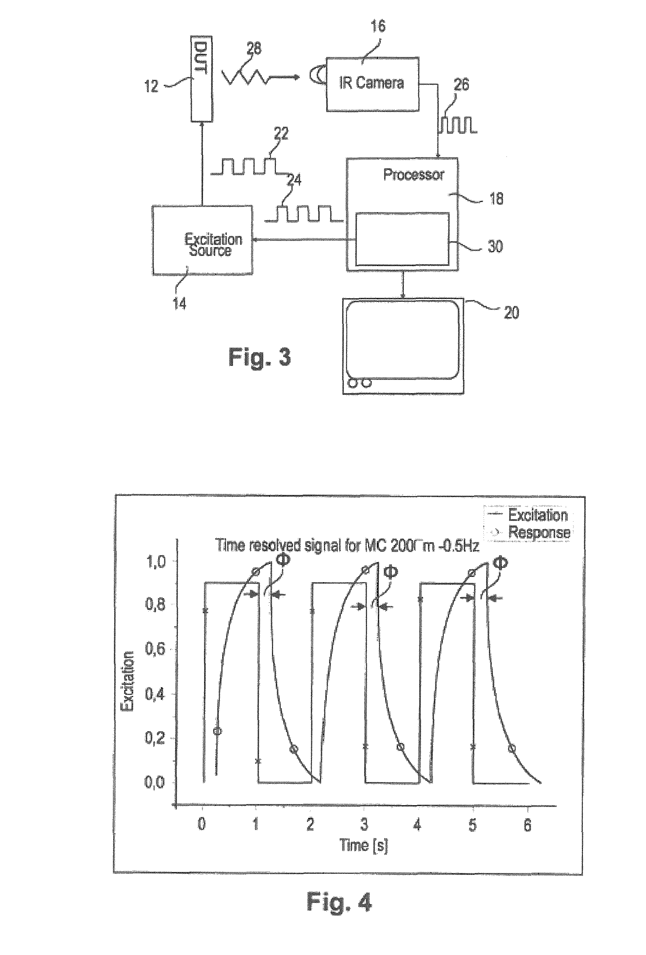

Fig. 3 is a schematic illustrating a system for performing LIT and which may be used to implement the methods of the invention as described below. A device under test (DUT) 12 is stimulated by excitation signal 22 at a lock-in frequency generated by excitation source 14. The lock-in frequency of the excitation signal is set by a central processing unit 18. While generally thermography may be performed using sinusoidal signal, since the DUT is a digital device, excitation signal 22 is an electrical rectangular or square wave signal designed to turn on and off various active elements, e.g., transistors, within the DUT. In both rectangular and square wave signals the amplitude alternates instantaneously between fixed maximum and minimum values, such that the frequency is the number of transitions per period, e.g., number of transitions per second. Thus, in essence the test signal 22 can be considered as a train of pulses at a given frequency.

A sync signal 24 is output from the central processing unit 18 and sent to the excitation source 14. The simplest way is to set the sync signal 24 at the desired lock-in frequency, although it may be set to a different frequency, so long as provisions are made to enable excitation source 14 to generate the excitation signal 22 at the desired lock-in frequency using the sync signal 24. As the excitation signals cause currents to flow in the DUT 12, anomalies inside the DUT 12 cause local hot spots. The heat from the hot spots then propagates inside the DUT 12 until it reaches the surface of the DUT 12, which faces IR camera 16. The IR camera may be a two-dimensional array sensor. Then heat rays 28 outputted from the surface of the DUT 12 to IR camera 16 are used to take IR images of surface of the DUT and to output image signals 26 to the central processing unit 18 including a processor 30. The frame rate of camera 16 is usually selected taking into account the lock-in frequency. In case of a 2-channel IR camera, the frame rate of the camera is 4-times the lock-in frequency. With the setup of Fig. 3, an identification of a hot spot's spatial and depth localization within the DUT 12 is possible. The processor 30 of the setup of Fig. 3 is configured to carry out the processing required in the invention as described below.

Fig. 4 illustrates a plot of the square-wave excitation signal and the IR response signal. The time delay between the end of the excitation signal and the response signal is the phase shift, marked by $\phi$. As explained above, the resulting phase shift would differ according to the frequency of the applied excitation signal. Therefore, to obtain accurate measurement of the depth, the measurement needs to be repeated many times at different frequencies, so as to obtain the plot illustrated in Fig. 2. On the other hand, according to the below described embodiment, the investigation can be concluded accurately using a single measurement at a single frequency, but obtaining the phase shifts corresponding to multiple excitation signals of multiple frequencies.

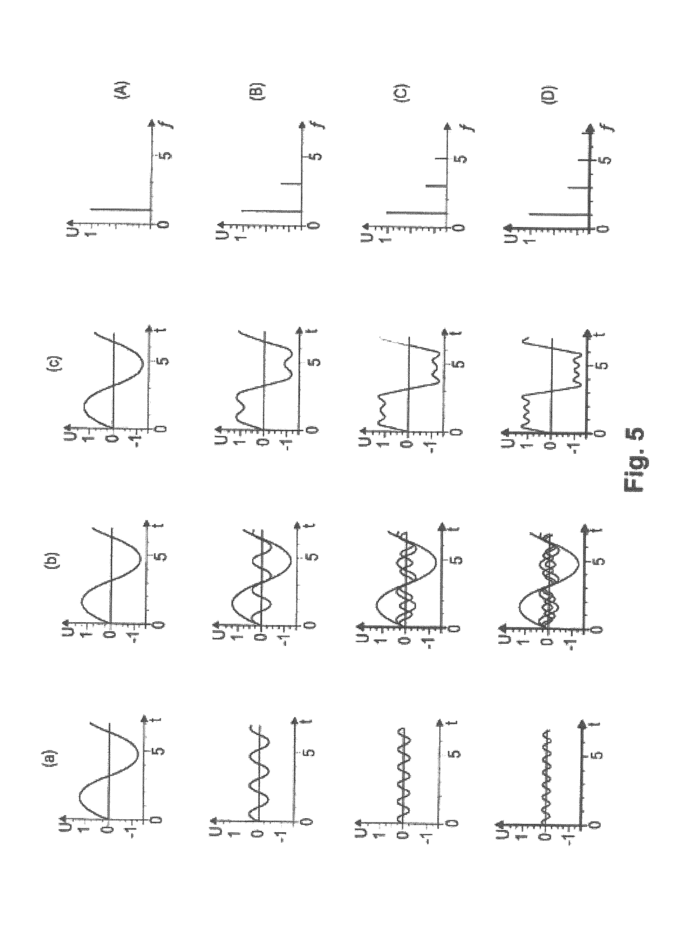

The diagram of Fig, 5 shows the basics behind the Fourier transformation, see also https://en.wikipedia.org/wiki/Fourier_transform. According to the Fourier transformation, each square wave can be approximated by superposition of several sine waves, where the approximation of the wave shape to a square wave pulse is improved as more harmonics of the sine wave at different frequencies are superimposed. In other words, any square wave can be broken down into sine waves having different frequencies as shown in Fig. 5.

In column (a) of Fig. 5 various sine curves are shown in a diagram of amplitude vs. time. The sine curves have different frequencies as can be seen from the diagrams in column (a). Column (b) shows in line (A) the sine wave, which may be considered as the fundamental, which also shown in column (a), line (A). Additional higher harmonics sine waves are shown superimposed on the fundamental sine wave of column (b). The diagram of column (b), line (B), shows the sine wave of the first line as well as the sine wave of the diagram on column (a), line (b), in a combined diagram. The diagram in column (c), line (B), shows the wave form which is generated by superimposing, i.e., adding, the line curves of column (a), line (A) and line (B). It can be seen that a square wave is approximated already in the diagram of column of (c), line (B). The diagram in column (c), line (C), shows the resulting curve from a superposition of the sine waves in column (a), lines (A), (B) and (C), wherein the square wave is better approximated as compared to the waves shape in column (c), line (B). The diagram in column (c), line (D) is a superposition of all four sine waves of column (a) and can a better approximation to a square wave pulse. As can be seen, the more higher-harmonics sine waves are added to the fundamental sine wave, the better the approximation of the non-harmonic square wave becomes.

As can be seen from the above explanation, any square wave can be broken down into sine waves having different frequencies as shown in Fig. 5. The Fourier transformation can break down any original signal only if the original signal does not have a sine-shape, i.e. if the signal is a non-harmonic signal. Therefore, by definition, a non-harmonic signal can have any shape except a sine-shape. Examples of a non-harmonic signal are square waves, triangle waves, saw tooth waves and the like. The following embodiments make use of this approach to localize the buried hot spots using excitation at only a single frequency.

It is noted that the use of a non-harmonic excitation signal, specifically of square or rectangular excitation signal, for investigation of IC's is not an impediment, but is rather natural. IC's have active devices, i.e., transistors, that are designed to assume different binary states according to applied binary signal. Thus, testing an IC using a binary square or rectangular signal is actually advantageous.

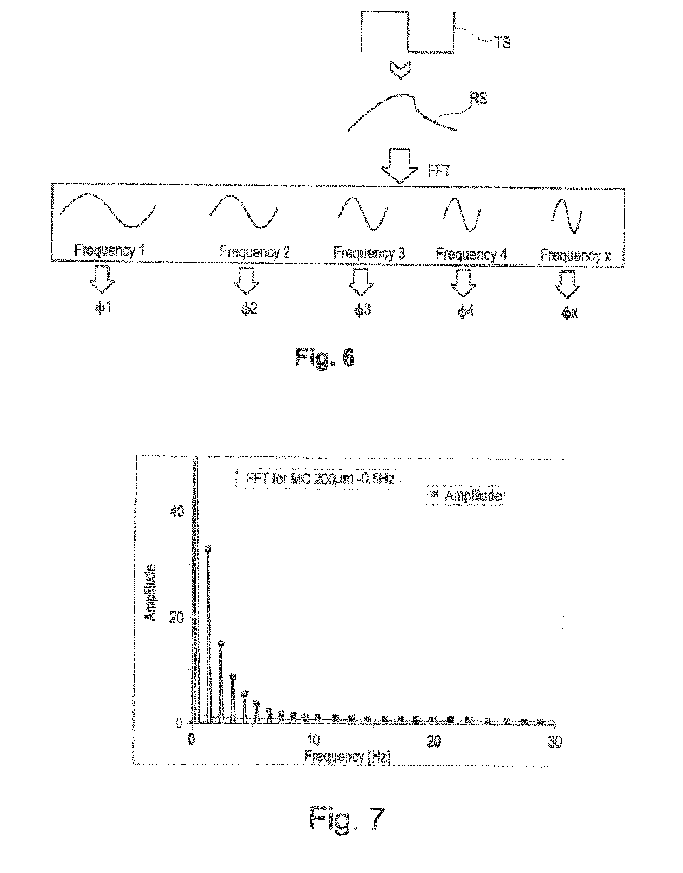

Therefore, according to the following embodiments, the DUT is excited by a non-harmonic, i.e., a square wave signal at only a single frequency. The single frequency is selected as the lowest frequency desired to be investigated. A Fourier Transform is then applied to the resulting response signal in order to extract a response signal corresponding to all desired excitation frequencies. This may be understood from the following. Fig. 6 shows an example of a square wave excitation pulse TS and the resulting response signal RS in a diagram of time vs. excitation intensity. In Fig. 6 only a single excitation pulse and a single response pulse are shown, but the excitation signal and IR response signal can be collected over multiple cycles. In one example, the frequency of the excitation signal is selected as 0.5 Hz. As a starting point, such a square wave excitation signal is applied to the electric circuit of the DUT as a non-harmonic test signal. While the test signal is applied to the DUT, the DUT is imaged by the infrared camera to obtain an IR image of the sample, which results in the response signal RS that is shown in Fig. 6. This thermal response signal RS is obtained from the IR camera's imaging and has a correlation to the thermal heat propagation within the DUT.

The thermal response signal RS is then subjected to a fast Fourier transformation (FFT), see https://en.wikipedia.org/wiki/Fast_Fourier_transform to break down the thermal response signal into a frequency specific spectrum containing at least the individual frequencies 1 to x, as shown in Fig. 6, where the frequencies 1 to x each show a specific phase shift $\phi$1 to $\phi$x, respectively. Such phase shifts $\phi$1 to $\phi$x are then plotted against the frequencies to obtain the frequency vs. phase shift curve. By means of the FFT, the measurement process per sample is further shortened because the results of the FFT are already individual frequency specific response signals at pre-selectable frequencies.

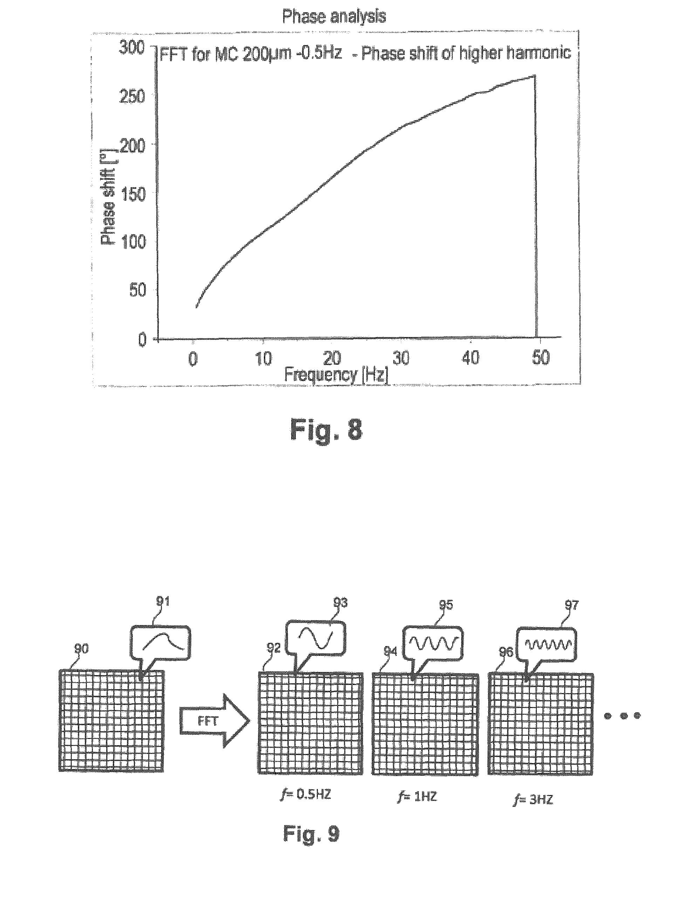

The effect of the fast Fourier transformation (FFT) is also shown in Fig. 7, showing a frequency vs. amplitude diagram of the result of the fast Fourier transformation (FFT). That is, the FFT changes the information from the time domain (i.e., plot of amplitude v. time) to the frequency domain (i.e., amplitude v. frequency). Fig. 7 shows that breaking down the thermal response signal RS by FFT results in a large number of individual specific peaks in amplitude related to the individual frequencies. Since the amplitude of the signals is also related to the phase shift caused by the sample and the respective frequencies, the results obtained from the diagram of Fig. 7 can be plotted as frequency vs. phase shift diagram as shown in Fig. 8.

It is to be noted that the frequencies related to the peaks in the diagram of Fig. 7 are the Frequencies 1 to Frequency x shown in Fig. 6. Such frequencies correspond to the harmonic signals associated with the basic harmonic signal (sine or cosine wave). In other words, the phase shifts of the frequencies specific response signals are determined at the multiple specific frequencies, and a frequency vs. phase shift curve can be obtained from the phase shifts of the frequency specific response signals (response signals at the Frequencies 1 to 4 and Frequency x) related to the depths location of the hot spot generated by the heat source.

The diagram of Fig. 8 is the frequency vs. phase shift curve for a DUT. The curve shown in Fig. 8 is obtained from a number of measurement points contained in the frequency range from 0.5 to 50 Hz and based on the peaks in the diagram of Fig. 7. It is to be noted that the frequency range is extended as compared to the measurement range shown in Fig. 7. However, in practice, at most four or five measurement points corresponding to the peaks in the diagram of Fig. 7 are sufficient in order to arrive at a basis for a satisfying result of the measurement method.

The diagram of Fig. 8 again shows the advantage of the system and the method according to the invention. i.e., that a particular frequency vs. phase shift curve can be obtained for a number of lock-in frequencies during one single measurement run using one non-harmonic test signal at one frequency as excitation energy for causing the sample to react in reply to the non-harmonic test signal, where the respective one single response signal is a further processed to obtain the frequency vs. phase shift curve. In other words, there is only one measurement at one frequency necessary for each type of the sample.

CHRISTIAN SCHMIDT et al and WO 2011/156527 AI teach how to derive the depth location of a defect from the frequency vs. phase shift curves. Therefore, the frequency vs. phase shift curve of Fig. 8 can be used as a basic information to determine the depth location of a defect.

Fig. 9 illustrates another feature of the invention. In Fig. 9, the image obtained at the end of a series of excitations at a single frequency is illustrated as the pixels 90 of the IR sensor. This image may be obtained by continuously averaging the live images so as to obtain an image of reduced signal to noise ratio (S/N). According to this feature, an image of the surface of the DUT which was generated at the end of a previous timed interval, is averaged with an image of the surface of the DUT taken at an end of a subsequent timed interval. As more images are captured at each subsequent interval, the images are continuously summarized and averaged step by step. Since the response signal stays the same, the noise is canceled out over time by this averaging process. Consequently, the resulting image 90 has an improved signal to noise ratio.

As illustrated by the callout 91, each pixel contains an individual response signal of a corresponding location on the DUT. According to this embodiment, a fast Fourier transformation is applied to each pixel, such that a response signal at a multitude of frequencies is obtained for each pixel. These images can be stored or displayed for the user.

That is, the user can arbitrarily select any specific frequencies, and the images corresponding to these frequencies can be generated and displayed using the single image 90, which was generated using excitation at a single non-harmonic frequency. In Fig. 9 this is exemplified as three images. 92, 94, and 96, each corresponding to a different frequency, e.g., 0.5Hz, 1 Hz, and 3Hz, respectively, such that each pixel shows the hot spot response of that frequency, as exemplified by callouts 93, 95, and 97, respectively.

It should be understood that processes and techniques described herein are not inherently related to any particular apparatus and may be implemented by any suitable combination of components. Further, various types of general purpose devices may be used in accordance with the teachings described herein. It may also prove advantageous to construct specialized apparatus to perform the method steps described herein.

The present invention has been described in relation to particular examples, which are intended in all respects to be illustrative rather than restrictive. Those skilled in the art will appreciate that many different combinations of hardware, software, and firmware will be suitable for practicing the present invention. Moreover, other implementations of the invention will be apparent to those skilled in the art from consideration of the specification and practice of the invention disclosed herein. It is intended that the specification and examples be considered as exemplary only, with a true scope of the invention being indicated by the following claims.

List of reference signs

| | |
|---|---|
| 12 | DUT |
| 14 | excitation source |
| 16 | camera |
| 18 | central processing unit |
| 20 | encapsulation |
| 22 | excitation signal |
| 23 | local heat source |
| 24 | sync signal |
| 26 | image signals |
| 27 | hot spot |
| 30 | processor |

**Claims**

1. A method for localizing a hot spot in a sample, in particular an encapsulated device under test (DUT), by using lock-in thermography (LIT), where at least one heat source of an electrical circuit is buried within the sample and generated the hot spot upon flow of current therein, comprising:

   applying a non-harmonic test signal to the electrical circuit of the sample to activate the heat source for generating the hot spot;
   imaging the sample using an infrared sensor to obtain IR image of the sample while the non-harmonic test signal is applied to the electrical circuit;
   subjecting the IR image to a Fourier transformation (FT) to break down the IR image into a frequency spectrum containing harmonics signals of a base and higher harmonic signals to thereby obtain a plurality of frequency-specific response signals at multiple specific frequencies; and,
   displaying at least one of the frequency-specific response signals.

2. The method of claim 1, further comprising determining the phase shifts of each of the frequency-specific response signals.

3. The method of claim 1, wherein applying a non-harmonic test signal comprises applying a square pulse test signal.

4. The method of claim 1, wherein the Fourier transformation is a fast Fourier transformation (FFT).

5. The method of claim 1, further comprising obtaining a frequency vs. phase shift curve from the phase shifts of the frequency-specific response signals.

6. The method of claim 5, further comprising smoothing the slope of the frequency vs. phase shift curve by square root function to improve the determination of the depth location.

7. The method of claim 1, further comprising:

   calculating a theoretical sample specific frequency vs. phase shift curve by analytical solution of the thermal wave propagation; or by finite element modeling of thermal wave propagation, and,
   correlating the theoretical sample specific frequency vs. phase shift curve to the measured frequency vs. phase shift curve to identify the depth location of the heat source in the sample.

8. The method of claim 1, wherein applying test signal comprises obtaining the test signal from an external source and synchronizing an IR camera as the infrared sensor to the signal from the external source.

9. The method of claim 1, wherein displaying at least one of the frequency-specific response signals comprises displaying a plurality of images, each corresponding to one of selected frequencies.

10. The method of claim 1, wherein applying a non-harmonic test signal comprises applying a non-harmonic signal at a single selected frequency.

11. A system for localizing a defect within a sample, in particular an encapsulated device under test (DUT), comprising:

    a bench for mounting the sample;
    an excitation source to apply a non-harmonic wave excitation test signal, preferably a square pulse test signal, to the sample;
    an infrared sensor, preferably an infrared camera, for imaging the sample to obtain IR images of the sample;
    wherein the processor is configured:

    to read data from the infrared sensor and use thermal imaging of the infrared sensor to generate thermal waveforms by;
    subjecting the response signal to a Fourier transformation (FT), preferably a fast Fourier transformation (FFT), to break down the response signal into frequency specific response signals at multiple frequencies; and analyzing the phase shifts at the multiple specific frequencies to thereby obtain a frequency vs. phase curve related to the depth of the hot spot in the sample.

12. The system of claim 11, comprising:

    a sync signal input configured for receiving sync signal corresponding to a non-harmonic test signal being applied to the electrical circuit of the sample to activate the heat source for generating the hot spot;
    an infrared sensor for imaging the sample to obtain IR images of the sample while the non-harmonic test signal is applied to the electrical circuit; and
    a processor configured to:

    receive the sync signal and operate the infrared sensor to capture a sequence of thermal images of the sample at time periods correlated to the sync signal;
    subject the sequence of thermal images to a Fourier transformation (FT), preferably a fast Fourier transformation (FFT), to break down the sequence of thermal images into a frequency spectrum containing harmonics signals of a base and higher harmonic signals to thereby obtain a plurality of frequency-specific response signals at multiple specific frequencies;
    display on a monitor at least one of the frequency-specific response signals.

13. The system of claim 11 or 12, wherein the infrared sensor comprises a two-dimensional array sensor and wherein the processor is configured to apply the FT to each pixel of the two-dimensional array sensor to obtain the frequency-specific response signals of each of the pixels.

14. The system of claim 11 or 12, wherein the processor is configured to display a plurality of IR images on the monitor using the frequency-specific response signals of each of the pixels, wherein each image corresponds to one of a selected frequency.

**15.** The system of claim 14, wherein the processor is further configured to obtain a frequency vs, phase shift curve from the determined phase shifts of the frequency specific response signals or a frequency specific image, respectively, related to the depth location of the sample.

**Amended claims in accordance with Rule 137(2) EPC.**

**1.** A method for localizing a hot spot (27) in a sample (12), in particular an encapsulated device under test (DUT), by using lock-in thermography (LIT), where at least one heat source (23) of an electrical circuit is buried within the sample (12) and generated the hot spot (27) upon flow of current therein, comprising:

applying a non-harmonic excitation wave test signal at a lock-in frequency to the electrical circuit of the sample (12) to activate the heat source (23) for generating the hot spot (27);
imaging the sample (12) using an infrared sensor (16) to obtain IR image of the sample (12) while the non-harmonic test signal is applied to the electrical circuit; and
detecting a thermal response signal obtained from the imaging, thermal response signal being in correlation to the thermal heat propagation within the sample (12),
**characterized in that**
applying the non-harmonic test signal comprises applying a non-harmonic signal at a single selected frequency; that
the thermal response signal is subjected to a Fourier transformation (FT) to break down the thermal response signal into a frequency spectrum containing harmonics signals of a base and
higher harmonic signals to thereby obtain a plurality of frequency-specific response signals at multiple specific frequencies; that
the phase shifts of each of the frequency-specific response signals is determined; that a frequency vs. phase shift curve is obtained from the phase shifts of the frequency-specific response signals; and that
a plurality of images, each corresponding to one of the specific frequencies are displayed.

**2.** The method of claim 1, wherein the Fourier transformation is a fast Fourier transformation (FFT).

**3.** The method of claim 1, wherein applying a non-harmonic test signal comprises applying a square pulse test signal.

**4.** The method of claim 1, further comprising smoothing the slope of the frequency vs. phase shift curve by square root function to improve the determination of the depth location.

**5.** The method of claim 1, further comprising:

calculating a theoretical sample specific frequency vs. phase shift curve by analytical solution of the thermal wave propagation; or by finite element modeling of thermal wave propagation, and,
correlating the theoretical sample specific frequency vs. phase shift curve to the measured frequency vs. phase shift curve to identify the depth location of the heat source (23) in the sample (12).

**6.** The method of claim 1, wherein applying test signal comprises obtaining the test signal from an external source and synchronizing an IR camera as the infrared sensor (16) to the signal from the external source.

**7.** A system for localizing a defect within a sample (12), in particular an encapsulated device under test (DUT), comprising:

a bench for mounting the sample (12);
an excitation source to apply a non-harmonic wave excitation test signal at a lock-in frequency to the sample (12);
an infrared sensor (16), preferably an infrared camera, for imaging the sample (12) to obtain IR images of the sample (12) while the non-harmonic test signal is applied to the electrical circuit;
wherein the processor (30) is configured:

to read data from the infrared sensor (16) and use thermal imaging of the infrared sensor (16) to generate thermal waveforms by;
applying the non-harmonic test signal at a single selected frequency;
subjecting the thermal response signal to a Fourier transformation (FT) to break down the thermal response signal into a frequency spectrum containing harmonics signals of a base and higher harmonic signals to thereby obtain a plurality of frequency-specific response signals at multiple specific frequencies;

determining the phase shifts of each of the frequency-specific response signals;

obtaining obtain a frequency vs, phase shift curve from the determined phase shifts of the frequency specific response signals or a frequency specific image, respectively, related to the depth location of the sample (12); and

displaying a plurality of images, each corresponding to one of the specific frequencies.

8. The system of claim 7, wherein the processor (30) is configured to subject the response signal to a fast Fourier transformation (FFT).

9. The system of claim 7, wherein the excitation source is configured to apply a square pulse test signal to the sample (12),

10. The system of claim 7, comprising:

a sync signal input configured for receiving sync signal corresponding to a non-harmonic test signal being applied to the electrical circuit of the sample (12) to activate the heat source (23) for generating the hot spot (27); wherein

the processor (30) is further configured to receive the sync signal and operate the infrared sensor (16) to capture a sequence of thermal images of the sample (12) at time periods correlated to the sync signal.

11. The system of claim 7, wherein the infrared sensor (16) comprises a two-dimensional array sensor and wherein the processor (30) is configured to apply the FT to each pixel of the two-dimensional array sensor to obtain the frequency-specific response signals of each of the pixels.

**Fig. 1**

**Fig. 2**

**Fig. 3**

**Fig. 4**

**Fig. 5**

EP 2 840 387 A1

**Fig. 6**

**Fig. 7**

**Fig. 8**

**Fig. 9**

**EUROPEAN SEARCH REPORT**

Application Number

EP 13 18 1506

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y,D | WO 2011/156527 A1 (DCG SYSTEMS INC [US]; FRAUNHOFER GES FORSCHUNG [DE]; ALTMANN FRANK [DE] 15 December 2011 (2011-12-15) * paragraph [0037] - paragraph [0057]; figures 4-8, 11A, 11B * | 1-15 | INV. G01N25/72 G01R31/309 |
| Y | Fernando Lopez Rodriguez ET AL: "NON-DESTRUCTIVE EVALUATION OF COMPOSITES MATERIALS BY PULSED-PHASE THERMOGRAPHY: DEPTH INVERSION", Proceedings of COBEM 2011, 28 October 2011 (2011-10-28), pages 1-11, XP055082429, Retrieved from the Internet: URL:http://emc.ufsc.br/labtermo/publica/ac 19_COB25761_2011 TIR.pdf [retrieved on 2013-10-03] * Introduction, 2.2 Principles of Pulsed Phase Thermography, 2.3 Data acquisition and processing in PPT; figures 1,2,7,8 * | 1-15 | |
| Y,D | CHRISTIAN SCHMIDT ET AL: "Non-destructive defect depth determination at fully packaged and stacked die devices using Lock-in Thermography", PHYSICAL AND FAILURE ANALYSIS OF INTEGRATED CIRCUITS (IPFA), 2010 17TH IEEE INTERNATIONAL SYMPOSIUM ON THE, IEEE, PISCATAWAY, NJ, USA, 5 July 2010 (2010-07-05), pages 1-5, XP031720074, ISBN: 978-1-4244-5596-6 * the whole document * | 1-15 | TECHNICAL FIELDS SEARCHED (IPC) G01N G01R |
| Y | US 6 812 468 B1 (BAUMANN JOACHIM [DE] ET AL) 2 November 2004 (2004-11-02) * column 2, lines 18-32; figures 1, 2 * | 1-15 | |

-/--

The present search report has been drawn up for all claims

| Place of search | Date of completion of the search | Examiner |
|---|---|---|
| The Hague | 16 October 2013 | Zwerger, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
......................................................................
& : member of the same patent family, corresponding document

EPO FORM 1503 03.82 (P04C01)

Europäisches
Patentamt
European
Patent Office
Office européen
des brevets

**EUROPEAN SEARCH REPORT**

Application Number

EP 13 18 1506

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MALDAGUE X ET AL: "PULSE PHASE INFRARED THERMOGRAPHY", JOURNAL OF APPLIED PHYSICS, AMERICAN INSTITUTE OF PHYSICS. NEW YORK, US, vol. 79, no. 5, 1 March 1996 (1996-03-01), pages 2694-2698, XP000593846, ISSN: 0021-8979, DOI: 10.1063/1.362662 * the whole document * | 1-15 | |

-----

TECHNICAL FIELDS
SEARCHED       (IPC)

The present search report has been drawn up for all claims

| Place of search | Date of completion of the search | Examiner |
|---|---|---|
| The Hague | 16 October 2013 | Zwerger, Markus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

...........................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 13 18 1506

This annex lists the patent family members relating to the patent documents cited in the above-mentioned European search report.
The members are as contained in the European Patent Office EDP file on
The European Patent Office is in no way liable for these particulars which are merely given for the purpose of information.

16-10-2013

| Patent document cited in search report | | Publication date | Patent family member(s) | | Publication date |
|---|---|---|---|---|---|
| WO 2011156527 | A1 | 15-12-2011 | CN | 103026216 A | 03-04-2013 |
| | | | EP | 2580583 A1 | 17-04-2013 |
| | | | JP | 2013526723 A | 24-06-2013 |
| | | | KR | 20130087487 A | 06-08-2013 |
| | | | SG | 186207 A1 | 30-01-2013 |
| | | | TW | 201215881 A | 16-04-2012 |
| | | | US | 2011297829 A1 | 08-12-2011 |
| | | | WO | 2011156527 A1 | 15-12-2011 |
| US 6812468 | B1 | 02-11-2004 | DE | 19837889 C1 | 21-12-2000 |
| | | | EP | 1110074 A2 | 27-06-2001 |
| | | | JP | 2002523739 A | 30-07-2002 |
| | | | US | 6812468 B1 | 02-11-2004 |
| | | | WO | 0011450 A2 | 02-03-2000 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011156527 A1

**Non-patent literature cited in the description**

- **CHRISTIAN SCHMIDT et al.** Non-destructive defect depth determination at fully packaged and stacked die devices using Lock-in Thermography. *PHYSICAL AND FAILURE ANALYSIS OF INTEGRATED CIRCUITS (IPFA, 2010), proceedings 17th IEEE International Symposium on the IEEE, NJ, USA,* 05 July 2010, ISBN 978-1-4244-5596-6, 1-5